Europäisches Patentamt

European Patent Office

Office européen des brevets

(11) Publication number: **0 254 550 B1**

# EUROPEAN PATENT SPECIFICATION

(45) Date of publication of patent specification: **14.10.92**

(51) Int. Cl.⁵: **B01D 61/00**, G03F 7/26, C02F 1/44, C02F 1/30

(21) Application number: **87306477.8**

(22) Date of filing: **22.07.87**

(54) **Treatment of photoresist materials containing waste solution.**

(30) Priority: **23.07.86 JP 171894/86**
**17.01.87 JP 7449/87**

(43) Date of publication of application:
**27.01.88 Bulletin 88/04**

(45) Publication of the grant of the patent:
**14.10.92 Bulletin 92/42**

(84) Designated Contracting States:
**AT BE CH DE ES FR GB GR IT LI LU NL SE**

(56) References cited:
**DE-A- 3 143 106**

**IBM TECHNICAL DISCLOSURE BULLETIN, vol. 25, no. 8, January 1983, page 4359, New York, US; S.R. BLANKS et al.: "Ultrafiltration for waste treatment"**

**CHEMICAL ABSTRACTS, vol. 104, no. 18, 5th May 1986, page 396, abstract no. 155202g, Columbus, Ohio, US; U. VON MYLIUS et al.: "Ultrafiltration - a simple and economical procedure for elimination of photoresist-loaded wastewater"**

(73) Proprietor: **SUMITOMO HEAVY INDUSTRIES, LTD**
**2-1 Ohtemachi 2-chome Chiyoda-ku**
**Tokyo 100(JP)**

(72) Inventor: **Miki, Kohei**
**1-chome 2-1-146 Minamihara**
**Hiratsuka-shi Kanagawa(JP)**
Inventor: **Saito, Hiroshi**
**4-chome 10-18 Higashikaigan-kita**
**Chigasaki-shi Kanagawa(JP)**

(74) Representative: **Bond, Bentley George et al**
**HASELTINE LAKE & CO. Hazlitt House 28**
**Southampton Buildings Chancery Lane**
**London, WC2A 1AT(GB)**

EP 0 254 550 B1

# EP 0 254 550 B1

**Description**

The present invention relates to the treatment of a photoresist-material-containing waste solution discharged from a printed circuit board manufacturing process, a printing industry, a semiconductor manufacturing industry or other industry using photoresist material. Particularly, it relates to treatment of photoresist resin containing waste solution in which the photoresist resin containing solution can be treated by a simple process so as to regenerate a developing solution or a stripping solution to be used, for example, in a printed circuit board manufacturing industry, by the recycling of the solution.

Printed circuit board manufacturing operations in which printed circuit boards are manufactured using water-soluble photoresist materials produce large volumes of waste water containing organic materials in solution.

The conventional treatment of the photoresist resin containing waste solution from a printed circuit board manufacturing factory does not involve any recovery of the photoresist containing solution but merely involves a treatment of the total quantity of the waste liquor. The waste solution discharged from the developing process and the stripping process of a printed-circuit board manufacturing industry is an alkaline solution containing water soluble photoresist material at a high concentration, and therefore, it has a high COD (Chemical Oxygen Demand), for example, 5,000 to 10,000 mg/l and a high BOD (Biochemical Oxygen Demand), for example, 1,000 to 3,000 mg/l. The treatment of such a waste solution to produce a harmless liquid requires a very complicated system for the treatment and raises the cost of the treatment process.

Among the prior art, the conventional techniques can be classified into two categories: one is biological treatment by the steps of acid-addition - biological treatment - absorption in active carbon. (Japanese Laid-open Patent Publication No. 50-4850 relating to an active sludge treatment) and the other one is a separation of a reverse osmosis membrane (see Japanese Laid-open Patent Publication No. 60-28881). The conventional biological treatment comprises reducing the pH of the waste solution to be treated by the addition of acid so as to make the dissolved photoresist material insoluble, separating the precipitated solid from the solution, neutralizing the solution by adding an alkalizing agent, diluting the solution to reduce the solubility of the organic materials, and then biological treating followed by filtration and absorption on active carbon particles. This process requires a large volume of acid and alkalizing agent, and further a large volume of diluting water, i.e. tens times the volume of the waste solution to be treated, and requires large scale equipment which will raise very much the cost of the treatment of the waste solution. Further, the biological treatment has a low treatment efficiency, and the COD removal is as low as below 50 percent, and the maintenance is not easy. The absorption with active carbon is required to reduce further the COD to enable the discharge of the treated waste solution into a river or a public water supply, which will raise the loading of the active carbon absorption and, therefore, raise the cost of the treatment.

The separation by using reverse osmosis membrane can not keep the concentration of the photoresist material in the waste solution high, because the waste solution contains inorganic material in an amount of the order of 2 percent. An increase of the concentration of the photoresist in the waste solution being treated to the extent of about 5 times that of the original waste solution is a practical limit because of the increase of the osmotic pressure. Therefore, one fifth of the waste solution will remain as a concentrated solution to be disposed of. The treatment using the reverse osmosis membrane is costly, and there are problems in its practical reliability. The waste solution from a developing process and a stripping process in a printed circuit board manufacturing industry is an alkaline solution in which water soluble photoresist material and anti-foaming agent are dissolved. Such a waste solution has high COD and BOD and therefore, will require a complicated system for the treatment of the waste solution and higher costs for the treatment.

It is known from IBM Technical Disclosure Bulletin, vol. 25, no. 8, page 4359 (January 1983) that ultrafiltration devices can be used to purify the developer and stripper used in such manufacture of printed circuit boards, so that the developer and stripper can be recycled.

Hitherto, the waste solutions from the developing process and stripping process, which may contain costly components, have been combined and treated together.

The present invention is based on the findings that dissolved photoresist material can be concentrated by an ultrafiltration membrane of the specific characteristics so as to produce a clean permeate passing through the ultrafiltration membrane, which can be used and recycled as a solution usable in the process for developing and stripping the photoresist layer, and that the photoresist material can be easily polymerized to form a solidified substance by exposure to electromagnetic radiation.

According to the present invention, there is provided a process for the treatment of an alkaline photoresist-material-containing waste solution discharged from an industry that uses a photoresist material, which comprises the steps of:

(a) subjecting the alkaline waste solution (which is one obtained by the treatment of the photoresist

2

material with a treating solution containing an alkalizing agent) to ultrafiltration through an alkaliresistant ultrafiltration membrane having a cut-off molecular weight value of from 5,000 to 100,000; and

(b) exposing the waste solution that has not passed through the ultrafiltration membrane in step (a) to electromagnetic radiation so as to polymerize the photoresist material dissolved in the solution thereby producing a polymerized substance and water.

Preferably, the process further comprises the steps of:

(c) returning the permeate passing through the ultrafiltration membrane to the treating solution so as to recycle the waste solution which has been subjected to the ultrafiltration; and

(d) adding an alkalizing agent which is the same as the one present in the treating solution to the permeate being recycled to the treating solution until the pH thereof becomes the original pH value of the treating solution before the treating of the photoresist material takes place.

Preferably, the process further comprises the step of:

(e) applying heat energy to the waste solution that has not passed through the ultrafiltration membrane thereby to cause the evaporation of water from the solution and also to accelerate the polymerization of the photoresist material dissolved in the solution.

Preferably, the heat energy is produced by burning of the polymerized substance produced by the polymerisation of the photoresist material.

Reference will be made hereinbelow, by way of example, to the drawings in which:

FIGS. 1a and 1b show schematically two typical systems for the treatment of photoresist material containing waste solution discharged from each of a developing process and a stripping process in a printed circuit board manufacturing industry, in accordance with the present invention;

FIG. 2 is a graph showing the performance of an ultrafiltration membrane in filtering a photoresist material; and

FIG. 3 is a graph showing the change of a solution regenerated and recycled repeatedly from a photoresist material containing waste solution treated in accordance with the present invention.

A photoresist is a photosensitive film applied over a support or a substrate, which is exposed to light or radiation and developed before etching. The exposed parts thereof function to protect against etching action. For example, a photoresist is applied for the production of circuit patterns on a printed circuit board. Further, photoresist techniques are used to manufacture a printing matrix for printing industries, a semiconductor pattern on a semiconductor device, and a variety of patterns used on various electronic devices. Accordingly, large volumes of photoresist materials are used in various industries and therefore, the wastes containing photoresist material are discharged from various processes such as a developing process, a stripping process and the other treating processes to dissolve photoresist materials formed on or over a support or a substrate.

The materials used for photoresist may include polymer(s) to form photoresist mask or layer, photosensitive monomer or oligomer as a cross-linking agent, photo-polymerization initiator, stabilizer if necessary, and colouring agent. The polymer(s) to form the photoresist mask or layer may be acrylic acid ester, methacrylic acid, itaconic acid and maleic acid as copolymerizable component, and further carboxyl groups as a side chain. The cross-linking agent may be a monomer or oligomer which may have an acryloyl group or methacryloyl group. The photo-polymerization initiator may be an anthraquinone analogue, benzophenone analogue, or benzoyl ether analogue. The stabilizer may be hydroquinone. The coloring agent may be a dyestuff such as blue coloring matter and green coloring matter.

When ultra violet light is applied to a photosensitive layer of the photoresist, the photo-polymerization initiator will generate radicals by a reaction responding to photons, and then those radicals will react with the linking agent to produce a chain reaction of photo-polymerization. The extent of the linkage will increase to a certain level so that the photoresist becomes insoluble in a developing solution. Therefore, the photoresist material, that can be indicated by the formula: R-COOH, will be dissolved in a developing solution by substituting the H group in the photoresist material with an Na ion in the developing solution and forming an Na salt in the solution. Further, in a stripping process, the photoresist materials remaining on the substrate will be partly dispersed, and partly dissolved in the solution upon stripping.

In accordance with the present invention, the photoresist material containing solutions discharged from each of a developing process and a stripping process and a treating process using photoresist material can be treated to regenerate and recycle the solution respectively to each of the original treating processes. Such treating processes are used in printed circuit board manufacturing industries, semiconductor manufacturing industries, printing industries and other industries for the production of the desired pattern or image on a surface of the work piece.

In accordance with the present invention, the waste solution is subjected to ultrafiltration, and the solution passing through the ultrafiltration membrane can be recycled to the original process. The part of the solution retained by the ultrafiltration membrane (i.e. not passing through the ultrafiltration membrane) is concentrated (or densified), so that the concentration of the photoresist material is raised. The resulting concentrated solution is exposed to electromagnetic radiation such as sun light and/or subjected to heat energy so as to accelerate polymerization of the photoresist material dissolved in the waste solution to thereby produce a solid of the polymerized (or cured) material. In one aspect of the present invention, further, the resulting solid is burned to heat the photoresist material containing waste solution thereby evaporating water from the solution and accelerating the polymerization of the photoresist material in the solution.

Hitherto, each of the waste solutions discharged from each of the processes for manufacturing are combined and treated together. In contrast, in accordance with the present process of waste treatment, each of the waste solutions from each of the processes is respectively treated so as to concentrate (or densify) the solution to, for example, about one tenth to one twentieth of the original volume of the waste solution. Therefore, the volume of waste solution to be treated and finally disposed of will be drastically reduced. The alkalizing agent contained in the waste solution such as from a developing process and from a stripping solution can be mostly recovered and reused as a permeate passing through the ultrafiltration membrane. The concentrated part of the waste solution, retained by the ultrafiltration membrane, is exposed to electromagnetic radiation such as sun light and/or subjected to heating so as to accelerate the polymerization of the photoresist material in the solution. The resulting solidified substance can be easily disposed of in a final step. Further, the resulting solid can be burned so that the heat of combustion can be used to heat more effectively the solution to thereby densify the solution or to accelerate the polymerization. Accordingly, the inventive process is very economical and produces harmless waste from the waste solution.

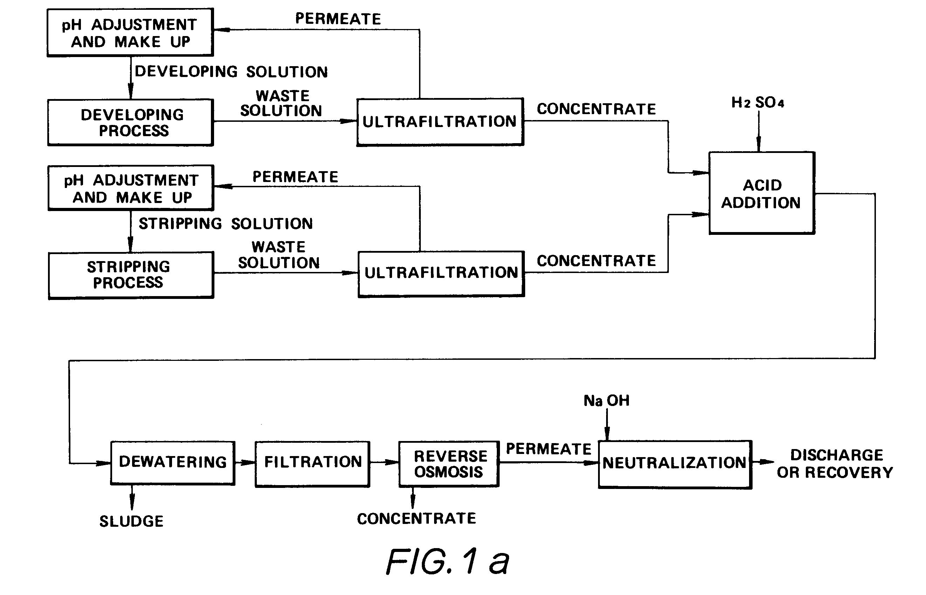

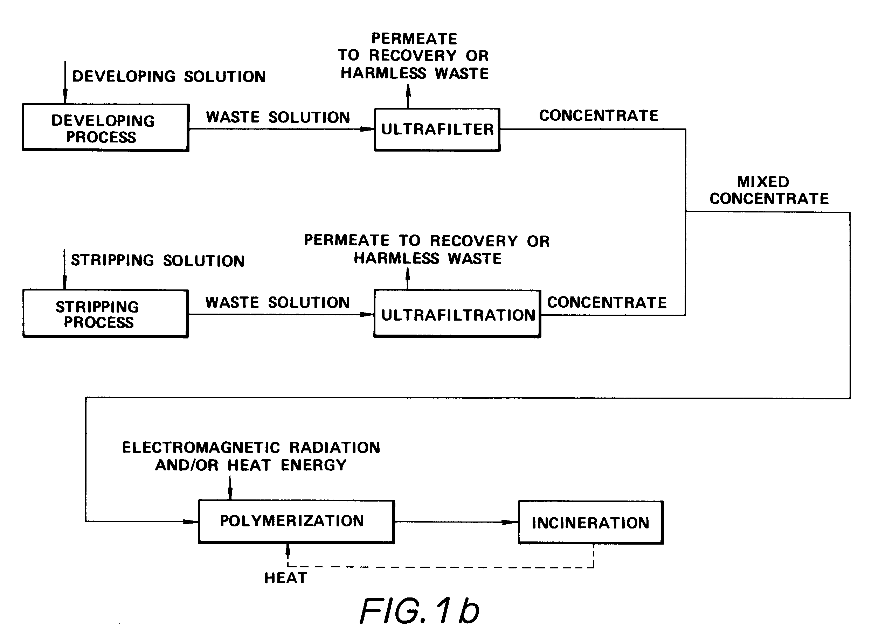

One process for the treatment of a photoresist material containing waste solution in accordance with the present invention is schematically shown in each of FIGS. 1a and 1b.

In accordance with the present invention, the waste solution consisting of photoresist material dissolved in a developing solution used in the developing process, or in a stripping solution used in the stripping process, is each subjected to ultrafiltration, while retaining its alkaline condition. The part of the solution passing through the ultrafiltration membrane is mostly free from the photoresist material and contains effective materials such as alkalizing agent and, therefore, can be recycled to the respective original process. In the case of the treatment of the waste solution from the developing process, the photoresist material does not pass through the ultrafiltration membrane and remains as a concentrated solution above the ultrafiltration membrane, and is then drawn off (i.e. is not recycled). Useful components such as alkalizing agent can pass through the ultrafiltration membrane and be returned to the developing solution to be again used for developing a photoresist layer on the substrate. In the case of the treatment of the waste solution from the stripping process, the part of the solution passing through the ultrafiltration membrane is again used to strip the photoresist layer remaining on the substrate after the etching step. In both cases, the part of the solution retained by the ultrafiltration membrane is concentrated in respect of the concentration of the photoresist material dissolved therein, and the volume of such concentrate solution is, for example, one tenth to one twentieth of the original volume of the waste solution.

The waste solution containing the soluble photoresist material to be treated in accordance with the present invention is an alkaline aqueous solution, for example one containing $Na_2CO_3$, NaOH and/or KOH in an amount of 1 to 2%. Such a waste solution is subjected to ultrafiltration with an ultrafiltration membrane having a cut-off molecular weight value of 5,000 to 100,000. The content of the dissolved photoresist materials is increased from, for example, 1.5 weight % to, for example, 15 weight % to 30 weight %. On the other hand, inorganic alkalizing agent having a lower molecular is not concentrated any more, and the content thereof in the concentrated waste solution is as much as 1 to 2%.

The nominal cut-off molecular weight of the ultrafiltration membrane is that molecular weight value in respect of which 90% of the material having this molecular weight is retained by the ultrafiltration membrane, using PEG or dextrane of known molecular weight for the measurement. The ultrafiltration membrane in practice has the same range for the nominal cut-off molecular weight as the range of pore size of the membrane.

In general, the developing solution may be an aqueous solution of 1 to 2 weight % $Na_2CO_3$ containing 0.1 to 0.5 volume % of polyalkylene glycol as an antifoamer. The stripping solution used in general may be an aqueous solution of 1 to 5 weight % NaOH or KOH, containing 0.1 to 0.5 volume % of polyalkylene glycol as an antifoamer.

The condition of enabling the treatment of the waste solution from the solution used in the printing circuit industry is dependent on a suitable combination of the characteristics of the ultrafiltration membrane and the composition of the waste solution. The ultrafiltration membrane used for the treatment of the waste solution in accordance with the present invention should satisfy the following conditions:

(1) The ultrafiltration membrane should be resistant to alkali because the waste solution to be treated is alkaline:

(2) The cut-off molecular weight should be in the range of about 5,000 to 100,000, depending on the composition of the waste solution, and therefore, the inorganic dissolved material will pass through the ultrafiltration membrane, and the photoresist material will be concentrated in the solution above the ultrafiltration membrane.

The claimed range is specified in view of the characteristics of the waste solution from the developing process or the stripping process, so as to carry out effectively the inventive treatment of the waste containing photoresist material. In general, an ultrafiltration membrane can remove a dissolved substance (solute) having the given molecular weight. The ultrafiltration membrane usable for the inventive process for the treatment of the waste solution should be adapted to remove effectively the photoresist material from the solution. In other words, the ultrafiltration membrane should be good at power of removing. The "power of rejecting" is defined as referring to the reduction of the concentration of the dissolved substance in the solution passing through the ultrafiltration membrane, from that thereof in the waste solution before the treatment. In other words, it can be referred to as the ratio of the concentration of the dissolved substance retained by the ultrafiltration membrane to that thereof in the waste solution before the treatment.

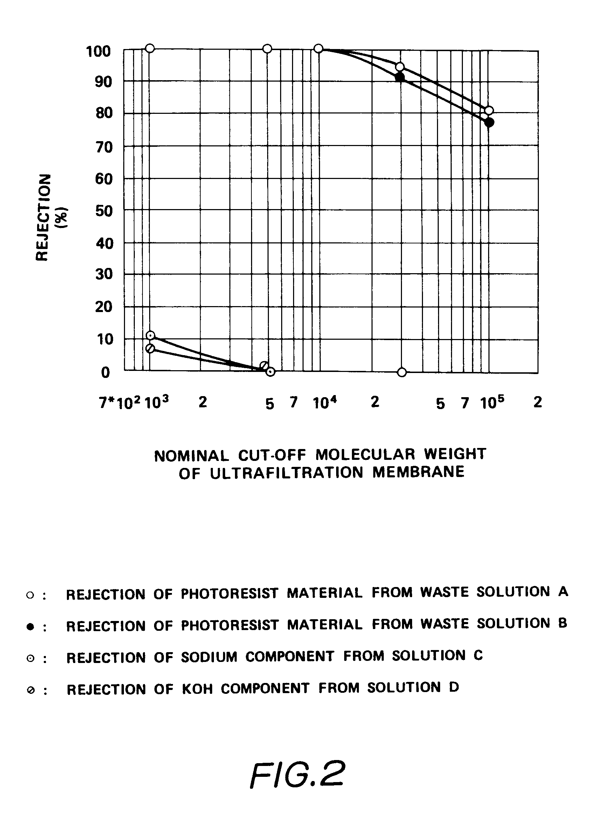

This rejecting power to photoresist material was tested by measuring the rejecting power of the ultrafiltration membrane to the waste solution containing an inorganic alkalizing agent and photoresist material. The result is shown in FIG. 2.

FIG. 2 is a plot of the rejecting power against the cut-off molecular weight of the ultrafiltration membrane and indicates:

(1) the rejection of photoresist material in a waste solution A from a developing process, containing 0.2 $m^2/l$ of photoresist material, and 1 weight % of $Na_2CO_3$:

(2) the rejection of photoresist material in a waste solution B from a stripping process, containing 0.3 $m^2/l$ of photoresist material, and 2 weight % of KOH:

(3) the rejection of sodium component ($NaHCO_3$) in a solution C containing 1 weight % of $Na_2CO_3$:

(4) the rejection of KOH component in a solution D containing 2 weight % of KOH:

The ultrafiltration membranes used for obtaining the data of FIG 2 are those available from Nippon Milipore Ltd. and Sumitomo Heavy Industries Ltd. and that consist of polysulfone on an appropriate support.

It is evident from FIG. 2 that the range of the cut-off molecular weight of the ultrafiltration membrane in which almost 100 % of photoresist material can be removed and most of alkalizing component can be recovered resides in the range 5,000 to 10,000.

The practical level for the developing power and the stripping power of the solution to be recycled in accordance with the present invention can be fixed lower than the level of the fresh solution. In this case, it can allow the leakage of the photoresist material from the waste solution to the permeate to a limited extent, and the range of the molecular weight of the ultrafiltration membrane is 5,000 to 100,000. Further, in accordance with the present invention, the volume of the fresh solution corresponding to the volume of the concentrated solution above the ultrafiltration membrane is added to the permeate solution to be recycled to each of the processes so as to resupply the same volume as that of the original solution. In this processing, the photoresist material content in the generated solution to be recycled is diluted by the added fresh solution and would be saturated to a certain level of the content of the dissolved photoresist material in a longer period of time.

The ultrafiltration membrane having the cut-off molecular weight ranging 5,000 to 100,000 can densify or concentrate most of the photoresist materials in the waste solution and let the alkalizing component pass through. The effective component, that is, the alkalizing component can be economically recovered by using an ultrafiltration membrane of such characteristics. On the other hand, the photoresist material can be removed in form of a condensed solution which can be easily disposed of. The range of the cut-off molecular weight of 5,000 to 100,000 corresponds to an average pore size of 0.002 to 0.05 micrometer of the ultrafiltration membrane. Therefore, very fine particles which are harmful in the production of a semiconductor device can be effectively removed in the inventive process for the treatment of the waste solution so as to recycle a solution usable in the production of a semiconductor device. This is one of the advantages of the inventive process.

The ultrafiltration membrane usable in accordance with the present invention may be composed of, as a membrane material, an inorganic metal oxide material such as zirconium dioxide, a polysulfone material, a polyimide material, or an acryl nitryl material which can constitute a membrane on an appropriate support for forming an ultrafiltration membrane. The configuration is preferably of tubular type. The cut-off molecular weight of the ultrafiltration membrane can be adjusted by controlling the amount of solvent in a coating material when applying a coating material to a support so as to form the ultrafiltration membrane, or in some other way such as by controlling the temperature or other condition in the manufacture of the membrane. The support material for the membrane may be a carbon sintered body or an aluminium silicate sintered body or the other formed passive body.

The following table 1 shows the pH of, and the components contained in:

(1) a developing solution used in a developing process for removing a photoresist material after the exposure of a water soluble photoresist resin to radiation;

(2) a waste developing solution to be treated after use in a developing treatment;

(3) a permeate, i.e. a solution of the developing waste, passing through an ultrafiltration membrane;

(4) a concentrated waste solution above the ultrafiltration membrane; and

(5) a stripping solution used in a stripping process for stripping a photo-cured (polymerized) photoresist resin after etching a conductive film (metal) for the production of printed circuit boards;

(6) a waste stripping solution after use in a stripping treatment;

(7) a permeate, i.e. a solution of the stripping waste, passing through an ultrafiltration membrane; and

(8) a concentrated waste solution above the ultrafiltration membrane.

Table 1

| process | solution | components contained in solution | pH |
|---|---|---|---|
| develop- ing | (1) developing | inorganic alkalizing agent, antifoamer | 11.5 |
| | (2) waste | uncured photoresist *material*, inorganic alkalizing agent, antifoamer | 10.5 |
| | (3) permeate | inorganic alkalizing agent, antifoamer | 10.5 |
| | (4) conce- ntrated | uncured photoresist *material*, inorganic alkalizing agent, antifoamer | 10.5 |
| stripp -ing | (5) stripping | inorganic alkalizing agent, antifoamer | 14.5 |
| | (6) waste | cured photoresist *material*, inorganic alkalizing agent, antifoamer | 13.5 |
| | (7) permeate | inorganic alkalizing agent, antifoamer | 13.5 |
| | (8) conce- ntrated | cured photoresist *material*, inorganic alkalizing agent, antifoamer | 13.5 |

It is necessary to adjust the pH of the solution to be recycled to the developing process, by adding an alkalizing component, because the alkalizing component in the solution has been consumed in the prior developing process, and the content of the alkalizing component in the recycled solution is insufficient for further development when the waste solution is treated by an ultrafiltration to yield the part of the solution passing the ultrafiltration membrane which is used to recycle to the developing solution used in the developing process. Further, when the inventive treatment of the waste solution containing photoresist material is applied to the stripping process, the solution which is to be recycled to the original stripping process is necessarily adjusted in the pH value in the similar way.

(1) NaOH can be added to adjust the pH of the developing solution to be recycled. However, if the Na ion concentration is too high, the photoresist material that must be dissolved in the stripping process is possibly dissolved in the preceding developing process.

In the inventive treatment of the waste solution, the accumulation of Na ion in the recycled solution can be avoided in the following way.

$Na_2CO_3$ dissociates as follows in the developing solution:

$$Na_2CO_3 + H_2O = NaHCO_3 + NaOH$$

Photoresist material (it is indicated by the formula: R-H) can be dissolved as follows:

$$Na_2CO_3 + H_2O \rightarrow NaHCO_3 + NaOH$$
$$NaOH + R\text{-}H \rightarrow R\text{-}Na + H_2O$$

As this reaction progresses, the NaOH is consumed, and the amount of $HCO_3^-$ is increased, and therefore, the power of dissolving is gradually lowered.

When the power of dissolving the photoresist material is too low, the solution is discharged and subjected to ultrafiltration. The part of the solution passing through the ultrafiltration membrane is mostly free from dissolved photoresist material, and contains only most of the inorganic alkalizing component(s).

When NaOH is added to the solution passing through the ultrafiltration membrane until the pH value becomes the original pH value before dissolving the photoresist material (pH = 11.5 in the case shown in Table 1), the following reaction takes place in the direction shown by the arrow:

$$Na_2CO_3 + H_2O \leftarrow NaHCO_3 + NaOH$$

It shows that if the amount of NaOH is increased, the equilibrium moves to the left side and $CO_3^{2-}$ ion is increased, which makes the solution fresh and regenerated.

Further, fresh developing solution is resupplied to the recycled solution in an amount corresponding to the loss of the solution which is the amount of the concentrated (densified) waste solution to be treated further. Accordingly, the volume of the waste solution to be discharge can be regenerated and recycled without the accumulation of Na ion in the solution, and without any fluctuations in the volume of the solution.

(2) The composition adjustment of the solution to be recycled in accordance with the present invention for the stripping process in a printed circuit board manufacturing industry is preferably done by adding a solution of NaOH or KOH to adjust the pH to about 14.

(3) The extent of concentration (densification) of the waste solution as a consequence of being subjected to ultrafiltration in accordance with the present invention will depend on factors such as the rate of the solution passing through the ultrafiltration membrane, and is preferably ten times to twenty times in practice.

In accordance with the present invention, the waste solutions discharged from both a developing process and a stripping process in a printed circuit manufacturing factory are respectively subjected to an ultrafiltration, and each of the permeates, that is, the parts of the solutions passing through the ultrafiltration membrane, are returned or recycled to each of the original processes, that is, the developing process or the stripping process, and further, the parts of the solutions concentrated above the ultrafiltration membrane are mixed or separately treated as shown in FIGS. 1a and 1b. The waste solution is treated as shown in FIGS. 1a and 1b.

In accordance with the present invention, each of the waste solution from the developing process and the stripping process is independently and separately treated so that each part of the solution passing through the ultrafiltration membrane is individually returned or recycled to each of the original processes, i.e. the developing process or the stripping process, and each of the concentrated solution above the ultrafiltration membrane is mixed so as to be treated further. Then, the mixed concentrated waste solution is treated in the following scheme, which constitute one aspect of the present invention.

Subsequent to the above described recovery process, the concentrated solution is treated as shown in FIG. 1a; in other words, neutralized by adding acid, and dewatered (hydro-extracted) with removal of dewatered sludge, filtered. Further, reverse osmosis, active carbon absorption, or biological treatment can be applied as a final step following the above procedure.

Alternatively, the concentrated solution can be treated as shown in FIG. 1b, which constitutes one aspect of the present invention. The concentrated photoresist material or its decomposed organic materials are cured or polymerized to form a solidified substance or solid by applying electromagnetic radiation or heat energy to the concentrated solution. This procedure is very economical. Such procedure is significantly effective particularly to the solution concentrated by the ultrafiltration in accordance with the present invention. The function of this procedure is described as follows.

The waste solution containing photoresist material contains further alkaline components used for dissolving the photoresist material, but photoresist material in general will be polymerized under acidic conditions such as below pH of 6 so as to solidify the concentrated waste solution. The solution concentrated by the ultrafiltration in accordance with the present invention is rich in photoresist material, and therefore, the photoresist material dissolved and concentrated in the waste solution can be polymerized even in alkaline solution so as to form the solidified substance incorporating water, and without any addition of acid or agent, it can be polymerized by exposing it to the electromagnetic radiation or heat energy. The polymerization begins to occur at the level of 50 to 60 weight % in its concentration. The polymerization can occur even in the presence of water, and therefore, the reaction does not require the step of separating photoresist material from the solution after the polymerization.

The following condition should be satisfied in order to carry out easily and economically the polymerization of the photoresist material in solution merely by exposing the solution to electromagnetic radiation such as sun light, and/or to heat energy.

The condition is that the concentrated solution should be at the lower level of the content of inorganic components such as alkalizing component, and the essential component dissolved is the photoresist material.

As shown in FIG. 1b, the waste solutions from the developing process and the stripping process are individually subjected to ultrafiltration, and each permeate passing through the ultrafiltration membrane is recycled to the respective process, or treated to produce harmless waste solution. On the other hand, the solution, concentrated in respect of photoresist material, above the ultrafiltration membrane is exposed to sun light so as to effect polymerization of the photoresist material. The polymerization can be accelerated by artificial light, as well as by sun light. Heat energy can be applied further to evaporate water from the solution, or to densify the solution, thereby accelerating the polymerization to produce a solidified substance incorporating water therein.

The operation condition should be selected depending on the type and the concentration of the photoresist material to be treated and the composition of the waste solution by controlling the alkaline adjustment, and the type and the number of the ultrafiltration membrane. The filtration of the waste solution by the ultrafiltration membrane results in a ten times to twenty times concentration of the solution, and the concentration of the photoresist material including decomposition products thereof becomes 15% to 30% by weight. In view of the foregoing, the inventive process of the treatment of the waste solution containing the photoresist material is very simple and economical without any need of chemicals to be added and can give a completely harmless waste to be disposed of.

In order to effect polymerization in the waste solution to produce an incineratable solid, the content of solute like alkalizing component should be at a low lever, and further, the concentration of the photoresist material should be at the level of about ten weight % which corresponds to a densification (concentration magnitude) of about ten times relative to the original waste solution. This concentration of photoresist material in the waste solution can be effected merely by subjecting it to the ultrafiltration in the previous step, so as to exclude photoresist material from the permeate of the ultrafiltration, in other words, to carry out an effective densification of the solution. It is important and effective to remove lower molecular weight components except photoresist material, and to keep the concentration of photoresist material at a high level.

The photoresist material dissolved in the waste solution can be polymerized or cured merely by exposing the solution to electromagnetic radiation and/or heat energy for a given period of time, so as to produce a solid substance. The electromagnetic radiation energy may be sun light and preferably may be light of 200 to 400 nm in wavelength, including the ultra violet range. Such suitable radiation is selected for the inventive process. The waste solution can be exposed to sun light by putting it in a pad or a plate or the like. The solidified polymerized material incorporates water and therefore, can be easily disposed of. Because the resulting solid is incineratable, if the solid is burned to recover heat energy to heat the waste solution, the waste solution can be more easily densified or concentrated by evaporating water from the solution, and the polymerization can be more easily effected. When the heat energy is applied, an indirect heating system such as drum drier is preferable, and the resulting solid is preferably picked up or scraped from the bottom of the container by a scraper. Further, the heat energy generated from burning the solid

EP 0 254 550 B1

can preferably be used to aid in heating the waste solution.

Tests to show the superiority of the treatment of photoresist material containing waste solution in accordance with the present invention are shown in the following examples, but they should not be interpreted as a limitation of the invention.

EXAMPLE 1

Densification of the photoresist concentration in the waste solution and recycling treatment of the solution

(1) Using an ultrafiltration membrane having a cut off molecular weight of 10,000, a waste solution from a developing process was subjected to ultrafiltration at a pressure of 20 kg/cm$^2$ and at a temperature of 20 to 30 °C to yield a solution to be recycled to the developing process. The tested regenerated solution has a constant dissolving power against photoresist material. The removal of organic material from the treated waste solution was about 80 percent. The removal is raised if an ultrafiltration membrane with smaller pores is used. When an ultrafiltration membrane with a cut off molecular weight of 5,000 was used, the removal was 85 percent. (The ultrafiltration membrane was made from polysulfone material, and in tubular form. The tested developing solution contained originally 1 weight % of Na$_2$CO$_3$ and 0.4 volume % of antifoamer and was used to develop an unexposed photoresist in a ratio of 0.17 m$^2$ of the photoresist per 1 litre of the developing solution at a temperature of 30 °C.)

The portion of the solution passing through the ultrafiltration membrane contained 15 to 20 percent of organic material which was the antifoamer originally contained in the developing solution. About 95 percent of the original developing solution volume can be recovered.

Through this ultrafiltration, the waste solution from a printed circuit board manufacturing industry was densified or concentrated, and the volume of the waste solution was reduced to one twentieth of the volume discharged from the developing process, resulting in a reduced volume of the waste to be disposed of.

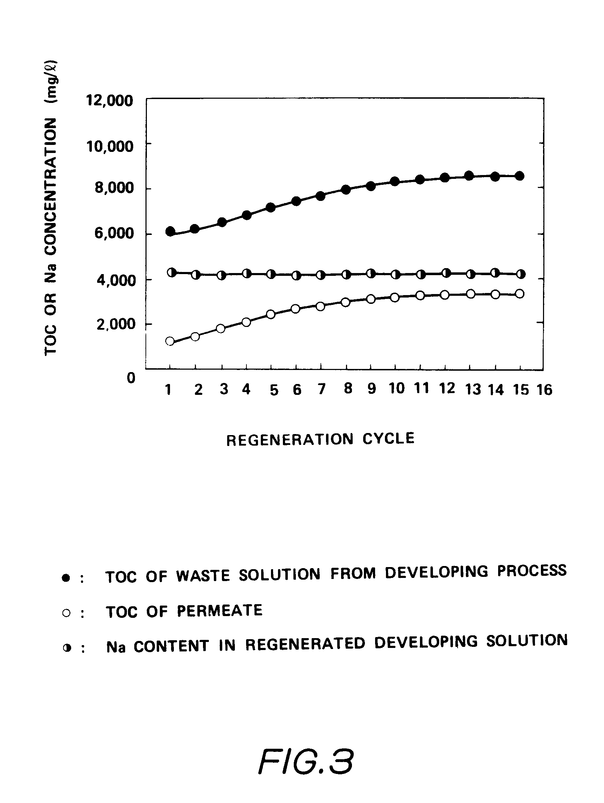

(2) Using the same developing solution as that used in (1), a test is carried out, adjusting the pH to 11.5, by subjected the developing solution to repeated ultrafiltration in a fractional operation to recycle the solution fifteen times, in accordance with the present invention. The content of Na ion and the amount of TOC (Total Organic Carbon), in each cycle, in the waste solution, the solution passing through the ultrafiltration membrane and the regenerated developing solution are shown in FIG. 3.

The ultrafiltration membrane was a film manufactured from polysulfone, having a cut off molecular weight of 10,000 and a film surface area of 0.012 m$^2$. The ultrafiltration was carried out at a pressure of 3 kg/cm$^2$, at a liquid temperature of 20°, and at a densification magnitude of 20 times.

Composition adjustment was carried out by adding NaOH to 950 ml of the solution passing through the ultrafiltration membrane, which had been obtained from 1,000 ml of the test waste solution (pH of 10.5), until the pH of the solution became 11.5, and then adding 50 ml of the fresh developing solution having the same composition as the original one to the recycled solution.

The solution was repeatedly regenerated in accordance with the present invention. It was confirmed that after the pH of the solution was adjusted at 11.5, the content of Na in the solution was constant. The solution passing through the ultrafiltration membrane was raised gradually in its content of dissolved photoresist material (as is shown by an increase of TOC). However, it was not densified endlessly. Because the new solution of 5% was added in one repeat to the regenerated solution, the content of TOC was balanced at the level corresponding to the dilution by such addition.

Treatment of photoresist densified waste solution

Then, the resulting concentrated waste was acidified by the addition of sulfuric acid to give a pH of 2 to 4. Thereby, most of the photoresist material (90 to 95%) was precipitated. The resulting precipitate was filtered from the waste solution, and then, the resulting filtrate was acidified and subjected to reverse osmosis treatment to result in about 5 times concentration (densification) of the original waste solution and further in a filtrate with a COD of below 20 mg/l, from which 99% of the dissolved photoresist material had been removed. The resulting clean filtrate is so clean that it can be put into a river or a public water supply, or it can be recovered as usable water.

Polymerization treatment of photoresist material in the densified waste solution

EXAMPLE 2

10

A waste solution containing soluble photoresist material discharged from a developing process in a printed circuit board manufacturing industry which original developing solution was adjusted to a pH of 10.5 by the addition of $Na_2CO_3$ and had a TOC of 6,000 mg/l, was subjected to ultrafiltration by a polysulfone membrane having a functional molecular weight of 10,000. The waste solution was densified 20 times to yield 200 ml of densified waste solution. The resulting solution was put in a glass pad of 200 mm x 250 mm and was exposed to sun light. After four hours, a solid material of 2 mm in thickness was obtained. The resulting solid material had a calorific value of 4,100 kcal/kg. at lower level and is easily incinerated.

EXAMPLE 3

A waste solution containing soluble photoresist material from a stripping process in a printed circuit board manufacturing industry, which original stripping solution was adjusted to a pH of 13.5 by the addition of KOH, and whose TOC was 10,000 mg/l was subjected to ultrafiltration similar to that of Example 2. The resulting densified waste solution was ten times concentrated and 200 ml in volume, and was exposed to sun light in a glass pad of 200 mm x 250 mm. After 3.5 hours, a solidified material similar to that of Example 2 was yielded. The water content of the resulting solidified substance was 50 weight percent. The calorific value at the lower level was 3,600 kcal/kg. This resulting solid was burned or incinerated as in Example 2.

REFERENCE EXAMPLE 1

200 ml of the waste solution used in Example 2 without the treatment by the ultrafiltration membrane was exposed to sun light in a glass pad of 200 mm x 200 mm. After it had been exposed to the sun light for 12 hours, the content of water was decreased to 52 weight percent, but there was not found any solid in the solution. Further, after it was dried for a further thirteen hours, there remained only a powdery deposit due to the inorganic alkalizing agent.

REFERENCE EXAMPLE 2

The waste solution used in Example 2 was subjected to ultrafiltration as in Example 2 to densify five times the solution. Then, 200 ml of the resulting densified solution was exposed to sun light in a pad of 200 mm x 250 mm. After nine hours, the content of water was reduced to 55 weight percent, but no solid was found. Further, after it was dried for a further ten hours, there remained only a powdery deposit due to the inorganic alkalizing agent.

REFERENCE EXAMPLE 3

The waste solution used in Example 2 was subjected to ultrafiltration as in Example 2 to densify eight times the solution. Then, 200 ml of the resulting densified solution was exposed to sun light in a pad of 200 mm x 250 mm. After seven hours, a partially cured solid was found. The resulting solid, incorporating white powder, showed insufficient cure (polymerization).

EXAMPLE 4

The waste solution used in Example 2 was subjected to ultrafiltration as in Example 2 to densify twenty times the solution. Then, 200 ml of the resulting densified solution was heated in a dark box for about one hour to reduce the water content to 57 weight %. The cured solid which was formed was incineratable.

Claims

1. A process for the treatment of an alkaline photoresist-material-containing waste solution discharged from an industry that uses a photoresist material, which comprises the steps of:
   (a) subjecting the alkaline waste solution (which is one obtained by the treatment of the photoresist material with a treating solution containing an alkalizing agent) to ultrafiltration through an alkali-resistant ultrafiltration membrane having a cut-off molecular weight value of from 5,000 to 100,000; and
   (b) exposing the waste solution that has not passed through the ultrafiltration membrane in step (a) to electromagnetic radiation so as to polymerize the photoresist material dissolved in the solution thereby producing a polymerized substance and water.

2. A process according to claim 1, which further comprises the steps of:
(c) returning the permeate passing through the ultrafiltration membrane to the treating solution so as to recycle the waste solution which has been subjected to the ultrafiltration; and
(d) adding an alkalizing agent which is the same as the one present in the treating solution to the permeate being recycled to the treating solution until the pH thereof becomes the original pH value of the treating solution before the treating of the photoresist material takes place.

3. A process according to claim 2, which further comprises the step of:
(e) applying heat energy to the waste solution that has not passed through the ultrafiltration membrane thereby to cause the evaporation of water from the solution and also to accelerate the polymerization of the photoresist material dissolved in the solution.

4. A process according to claim 3, wherein the heat energy is produced by burning of the polymerized substance produced by the polymerization of the photoresist material.

5. A process according to claim 1, which further comprises the steps of:
(c) burning the polymerized substance so as to produce heat energy; and
(d) applying the heat energy to the waste solution that has not passed through the ultrafiltration membrane thereby to cause the evaporation of water from the solution and also to accelerate the polymerization of the photoresist material dissolved in the solution.

**Patentansprüche**

1. Verfahren für die Behandlung einer bei Photoresistmaterial benutzender Industrie anfallenden, alkalischen Photoresistmaterial enthaltenden Abfallösung, mit den Schritten
a) daß die alkalische Abfallösung (welche durch die Behandlung des Photoresistmaterials mit einer ein alkalisierendes Mittel enthaltenden Behandlungslösung erhalten wird) einer Ultrafiltration durch eine alkalibeständige Ultrafiltrationsmembran mit einem Molekulargewichtssperrwert von 5000 bis 100.000 unterworfen wird, und
b) daß die beim Schritt a) nicht durch die Ultrafiltrationsmembran hindurchgegangene Abfallösung einer elektromagnetischen Strahlung ausgesetzt wird, um das in der Lösung enthaltene Photoresistmaterial zu polymerisieren, wobei eine polymerisierte Substanz und Wasser erzeugt werden.

2. Verfahren nach Anspruch 1 mit den Schritten,
c) daß der durch die Ultrafiltrationsmembran hindurchgegangene Teil in die Behandlungslösung zurückgebracht wird, um die der Ultrafiltration unterworfene Abfallösung zu rezirkulieren, und
d) daß dem zur Behandlungslösung rezirkulierten hindurchgegangenen Teil ein alkalisierendes Mittel, welches gleich dem in der Behandlungslösung vorhandenen ist, hinzugefügt wird, bis der pH-Wert der Behandlungslösung gleich deren ursprünglichem pH-Wert vor dem Stattfinden der Behandlung des Photoresistmaterials wird.

3. Verfahren nach Anspruch 2, mit den Schritten
e) daß auf die nicht durch die Ultrafiltrationsmembrane hindurchgegangene Abfallösung Wärmeenergie ausgeübt wird, wobei die Verdampfung von Wasser aus der Lösung bewirkt und die Polymerisation des in der Lösung gelösten Photoresistmaterials beschleunigt wird.

4. Verfahren nach Anspruch 3, wobei die Wärmeenergie durch Verbrennen der durch Polymerisation des Photoresistmaterials erzeugten polymerisierten Substanz erzeugt wird.

5. Verfahren nach Anspruch 1, mit den Verfahrensschritten,
c) daß die polymerisierte Substanz zur Erzeugung der Wärmeenergie verbrannt wird, und
d) daß die Wärmeenergie auf die nicht durch die Ultrafiltrationsmembran hindurchgegangene Abfallösung ausgeübt wird, wobei die Verdampfung von Wasser aus der Lösung und die Polymerisation des in der Lösung gelösten Photoresistmaterials beschleunigt wird.

**Revendications**

1. Procédé de traitement d'une solution alcaline usée contenant une matière de réserve photographique, provenant d'une installation industrielle qui utilise une matière de réserve photographique, le procédé comprenant les étapes suivantes :

   (a) le traitement de la solution alcaline usée (qui est obtenue par traitement de la matière de réserve photographique par une solution de traitement contenant un agent d'alcalinisation) par une ultrafiltration dans une membrane d'ultrafiltration résistant aux matières alcalines, ayant une valeur de masse moléculaire de coupure comprise entre 5 000 et 100 000, et

   (b) l'exposition de la solution usée qui n'a pas traversé la membrane d'ultrafiltration dans l'étape (a) à un rayonnement électromagnétique, afin que la matière de réserve photographique dissoute dans la solution polymérise et forme une substance polymérisée et de l'eau.

2. Procédé selon la revendication 1, qui comprend en outre les étapes suivantes :

   (c) le renvoi de la matière filtrée qui a traversé la membrane d'ultrafiltration vers la solution de traitement afin que la solution usée qui a été soumise à l'ultrafiltration soit recyclée, et

   (d) l'addition d'un agent d'alcalinisation, qui est le même que celui qui est présent dans la solution de traitement, dans la matière qui a traversé et qui est recyclée dans la solution de traitement, jusqu'à ce que son pH prenne la valeur du pH original de la solution de traitement avant le traitement de la matière de réserve photographique.

3. Procédé selon la revendication 2, qui comprend en outre l'étape suivante :

   (e) l'application d'énergie thermique à la solution usée qui n'a pas traversé la membrane d'ultrafiltration afin que l'eau s'évapore de la solution et que la polymérisation de la matière de réserve photographique dissoute dans la solution soit accélérée.

4. Procédé selon la revendication 3, dans lequel l'énergie thermique est produite par combustion de la substance polymérisée produite par polymérisation de la matière de réserve photographique.

5. Procédé selon la revendication 1, qui comprend en outre les étapes suivantes :

   (c) la combustion de la substance polymérisée afin qu'elle produise de l'énergie thermique, et

   (d) l'application d'énergie thermique à la solution usée qui n'a pas traversé la membrane d'ultrafiltration, afin que l'eau de la solution s'évapore et aussi que la polymérisation de la matière de réserve photographique dissoute dans la solution soit accélérée.

FIG.1 a

MIXED CONCENTRATE

CONCENTRATE

PERMEATE TO RECOVERY OR HARMLESS WASTE

DEVELOPING SOLUTION

DEVELOPING PROCESS

WASTE SOLUTION

ULTRAFILTER

PERMEATE TO RECOVERY OR HARMLESS WASTE

STRIPPING SOLUTION

STRIPPING PROCESS

WASTE SOLUTION

ULTRAFILTRATION

CONCENTRATE

ELECTROMAGNETIC RADIATION AND/OR HEAT ENERGY

POLYMERIZATION

HEAT

INCINERATION

FIG. 1b

NOMINAL CUT-OFF MOLECULAR WEIGHT
OF ULTRAFILTRATION MEMBRANE

o :  REJECTION OF PHOTORESIST MATERIAL FROM WASTE SOLUTION A

● :  REJECTION OF PHOTORESIST MATERIAL FROM WASTE SOLUTION B

⊙ :  REJECTION OF SODIUM COMPONENT FROM SOLUTION C

⊘ :  REJECTION OF KOH COMPONENT FROM SOLUTION D

*FIG.2*

FIG.3

● : TOC OF WASTE SOLUTION FROM DEVELOPING PROCESS

○ : TOC OF PERMEATE

◑ : Na CONTENT IN REGENERATED DEVELOPING SOLUTION